# EUROPEAN PATENT APPLICATION

(11) **EP 1 261 241 A1**
(43) Date of publication of application: **27.11.2002**
(21) Application number: 02253403.6
(22) Date of filing: 15.05.2002
(51) Int. Cl.: H05K 1/18, H01C 7/00

(54) **Resistor and printed wiring board embedding those resistor**

(30) Priority: 17.05.2001 US 291353 P
(71) Applicant: Shipley Co. L.L.C., Marlborough, MA 01752 (US)
(72) Inventor: Schemenaur, John, Tustin, California 92780 (US); Senk, David D., Mission Viejo, California 92692 (US)
(74) Representative: Kent, Venetia Katherine

(57) **Abstract**

Resistors having a resistive material portion including multiple layers or resistive materials, wherein each layer of resistive material has a different sheet resistivity, are provided by the present invention. Such resistors are particularly useful as embedded resistors in the manufacture of printed wiring boards. Methods of preparing such resistors are also provided.

## Description

### Background of the Invention

The present invention relates generally to the field of resistive materials. In particular, the present invention relates to the field of resistive materials suitable for use as embedded resistors in electronic devices.

Printed circuit boards typically include large numbers of electronic devices which are commonly surface mounted and also additional components which may be present in the form of active layers within each printed circuit board. The requirements for the devices and components in such printed circuit boards are subject to conventional electronic design restraints. In particular, many of the surface mounted devices and other components on such printed circuit boards commonly require coupling with individual resistors in order to achieve their desired function.

The most common solution to this problem in the prior art has been the use of individual resistors as additional surface mounted components on the printed circuit boards. Design of the printed circuit boards has further required the provision of through-holes in order to properly interconnect the resistors. In this regard, the resistors may be interconnected between any combination of surface devices or components or active components or layers formed on or within the printed circuit boards.

As a result, the complexity of the printed circuit boards has increased and at the same time the available surface area of the printed circuit boards for other devices has decreased or else the overall size of the printed circuit boards has increased to accommodate necessary surface devices and components including resistors.

One solution to this has been the use of planar resistors preferably formed on internal layers of the printed circuit boards in order to replace surface mounted resistors as described above while making surface portions of the printed circuit boards free for other uses. For example, U.S. Patent No. 4,808,967 (Rice et al.) discloses a printed wiring board having a support layer, a layer of electrical resistance material adhering to the support layer, and a conductive layer adhering to the electrical resistance layer.

A problem with certain conventional planar resistors is that the resistance measured in a first direction may differ slightly from the resistance measured in a second direction orthogonal to the first direction. If care is not taken in the manufacture of an electronic device, such as a printed wiring board, such planar resistors may be used in the wrong orientation. In such cases, the actual resistivity of may differ from that desired, thus adversely affecting the performance of the printed wiring board.

One of the objections to adopting embedded resistor technology in printed wiring board manufacture is that such resistor technology is limited in the range of values that it can provide. Unless large serpentine patterns are employed, a single layer of embedded resistor material is limited to about three decades of values, such as, for example, from 50 ohms to 5,000 ohms. In order to accommodate values above this range one must place discrete resistors on the surface of the printed wiring board, which negates some of the gain from embedding the resistor within the board, or alternatively, use a second sheet of higher resistivity material, which carries a higher cost of materials penalty.

There is thus a need for a resistive material having a resistivity that is dependent on the orientation of the embedded resistor.

### Summary of the Invention

It has been surprisingly found that printed wiring boards can be prepared having two different sheet-resistivities within a single layer (or plane) of the board. In particular, it has been surprisingly found that multilayer resistors can be prepared.

In one aspect, the present invention provides a printed wiring board including a resistor embedded within a dielectric material, wherein the resistor includes a resistive material portion including a first resistive material and a second resistive material. Typically, the resistive material portion includes a layer of each of the first and second resistive materials.

In another aspect, the present invention provides a method of manufacturing a printed wiring board including the step of embedding a resistor within an organic dielectric material, wherein the resistor includes a resistive material portion including a first resistive material and a second resistive material.

In a further aspect, the present invention provides a resistor having a resistive material portion including a first resistive material and a second resistive material and a pair of electrodes, each electrode being disposed at opposite ends of the resistive material portion.

In yet another aspect, the present invention provides an electronic device including a resistor and/or a printed wiring board as described above.

### Brief Description of the Drawing

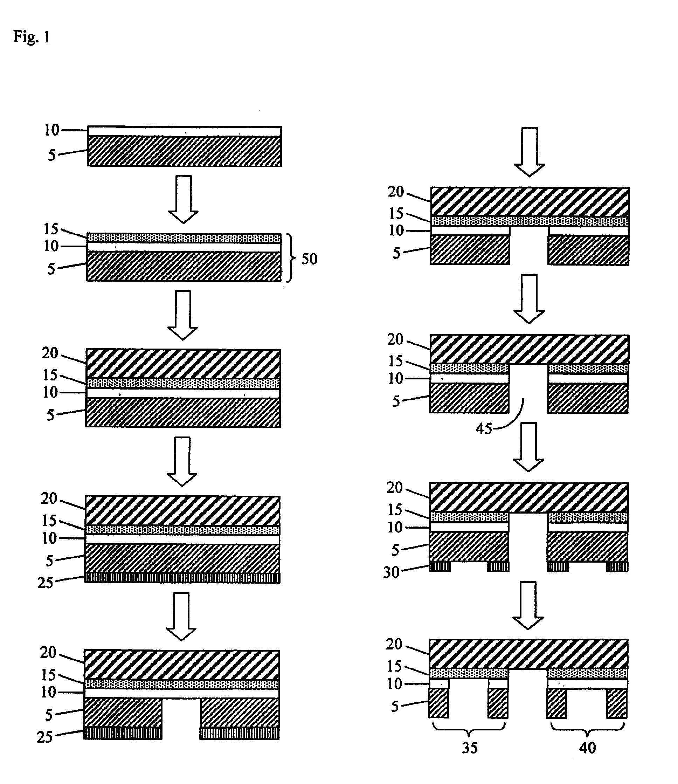

Fig. 1 illustrates one method of manufacturing a multilayer resistor of the invention.

### Detailed Description of the Invention

As used throughout this specification, the following abbreviations shall have the following meanings, unless the context clearly indicates otherwise: ° C = degrees centigrade; ° F = degrees Fahrenheit; nm = nanometer; µm = micron = micrometer; Å = angstrom; Ω = Ohms; Ω/□ = Ohms per square; M = molar; wt % = percent by weight; and mil = 0.001 inch.

The terms "printed wiring board" and "printed circuit board" are used interchangeably throughout this specification. Unless otherwise noted, all amounts are percent by weight and all ratios are by weight. All numerical ranges are inclusive and combinable in any order, except where it is obvious that such numerical ranges are constrained to add up to 100%.

The present invention provides a resistor having a resistive material portion including two or more resistive material layers and a pair of electrodes, each electrode being disposed at opposite ends of the resistive material. The resistive material portion of the present resistors are prepared by providing at least a layer of a first resistive material and a layer of a second resistive material. Additional layers of resistive material may be used, such as three, four, five or more layers. The specific number of layers is determined by the design characteristics of the resistor desired. For example, two layers of resistive materials are required to provide a resistor having 2 possible different resistivities, three layers of resistive materials are required to provide a resistor having 3 possible different resistivities, and so forth.

One characteristics of the present resistors is that each layer of resistive material in the resistive material portion has a different sheet resistivity from the other resistive material layers. No particular difference in sheet resistivity is required. The sheet resistivities of the different resistive material layers may not be very different or may be different by as much as 10 Ω/□ or greater. Particularly suitable differences in sheet resistivities between the first and second resistive material layers is 25 Ω/□, 50 Ω/□, 100 Ω/□, 250 Ω/□, 500 Ω/□ or greater. In another embodiement, there is a 10, 20, 25, or 50 fold or greater difference in sheet resistivities between the first and second resistive material layers.

A wide variety of resistive materials are suitable for use in the present invention, including but not limited to, a mixture of a conductive material and a minor amount of a highly resistive (dielectric) material. A very small amount of the highly resistive material, e.g., about 0.1 wt % to about 20 wt %, very profoundly reduces the conductive properties of the conducting material. For example, platinum, though an excellent conductor, when co-deposited with between 0.1 and about 5 wt % silica, serves as a resistor, the resistance being a function of the level of silica co-deposited. Any conductive material is suitable, such as, but not limited to, platinum, iridium, ruthenium, nickel, copper, silver, gold, indium, tin, iron, molybdenum, cobalt, lead, palladium, and the like. Suitable dielectrics include, but are not limited to, metal oxides or metalloid oxides, such as silica, alumina, chromia, titania, ceria, zinc oxide, zirconia, phosphorous oxide, bismuth oxide, oxides of rare earth metals in general, phosphorus, and mixtures thereof.

Preferred electrically resistive materials are nickel-based or platinum-based, i.e., the major material is nickel or platinum, respectively. Suitable preferred resistive materials are nickel-phosphorus, nickel-chromium, nickel-phosphorus-tungsten, ceramics, conductive polymers, conductive inks, platinum-based materials such as platinum-iridium, platinum-ruthenium and platinum-iridium-ruthenium. Preferred platinum-based materials contain from about 10 to 70 mole percent iridium, ruthenium or mixtures thereof, and preferably 2 mole percent to 50 mole percent, calculated relative to platinum being 100 percent. If ruthenium is used alone (without iridium), it is preferably used at between about 2 and about 10 mole percent calculated relative to platinum being 100 percent. If iridium is used alone (without ruthenium), it is preferably used at between about 20 and about 70 mole percent calculated relative to platinum being 100 percent. In the resistive materials in accordance with the invention, the iridium, ruthenium or mixtures thereof exist in both elemental form and in oxide form. Typically, the iridium, ruthenium or mixtures thereof are from about 50 to about 90 mole percent elemental metal and from about 10 to about 50 mole percent oxide(s) of the iridium, ruthenium or mixtures thereof.

The thickness of each resistive material layer may vary over a wide range. Preferably, each layer of resistive material has a thickness of up to 1 mil. For use in embedded resistors, each layer of resistive material is typically at least about 40 Å thick. In general, the thickness of each resistive material layer is from 40 to 100,000 Å (10 microns), preferably from 40 to 50,000 A, and more preferably from 100 to 20,000 Å.

While the first resistive material layer may be self-supporting, it is typically too thin to be self-supporting and must be deposited on a substrate which is self-supporting. The resistive materials are typically supported by being disposed on a conductive material substrate, such as a metal foil. Other suitable conductive materials are well known to those skilled in the art. Suitable metal foils include, but are not limited to, copper foil, nickel foil, silver foil, gold foil, and the like as well as alloys thereof. Conductive metal foils suitable for use in the present invention may have a wide range of thicknesses. Typically, such conductive metal foils have nominal thicknesses ranging from 0.0002 to 0.02 inches. Metal foil thicknesses are often expressed in terms of weights. For example, suitable copper foils have weights of from 0.125 to 14 ounces per square foot, more preferably 0.25 to 6 ounces per square foot, and still more preferably from 0.5 to 5 ounces per square foot. Particularly suitable copper foils are those having weights of 3 to 5 ounces per square foot. Suitable conductive metal foils may be prepared using conventional electrodeposition techniques and are available from a variety of sources, such as Oak-Mitsui or Gould Electronics.

The conductive material substrates may further include a barrier layer. Such barrier layer may be on the first side of the conductive material, i.e. the side nearest the resistive material, the second side of the conductive layer or on both sides of the conductive layer. Barrier layers are well known to those skilled in the art. Suitable barrier layers include, but are not limited to, zinc, indium, tin, nickel, cobalt, chromium, brass, bronze and the like. Such barrier layers may be deposited electrolytically, electrolessly, by immersion plating, by sputtering, by chemical vapor deposition, combustion chemical vapor deposition, controlled atmosphere chemical vapor deposition, and the like. Preferably, such barrier layers are deposited electrolytically, electrolessly or by immersion plating. In one embodiment, when the conductive layer is a copper foil, it is preferred that a barrier layer is used.

Following the application of a protective barrier layer, a protective layer of chromium oxide may be chemically deposited on the barrier layer or the conductive material. Finally, a silane may be applied to the surface of the conductive material/barrier layer/optional chromium oxide layer in order to further improve adhesion. Suitable silanes are those disclosed in U.S. Patent No. 5,885,436 (Ameen et al.).

Each layer of resistive material may be deposited by a variety of means, such as sol-gel deposition, sputtering, chemical vapor deposition, combustion chemical vapor deposition ("CCVD"), controlled atmosphere combustion chemical vapor deposition ("CACCVD"), spin coating, roller coating, silk screening, electroplating, electroless plating and the like. The first layer of resistive material, if not self-supporting, is deposited on the substrate. The second layer of resistive material is deposited on the first resistive material layer. Subsequent layers of resistive material are optionally then deposited. For example, nickel-phosphorus resistive materials may be deposited by electroplating. See, for example, International Patent Application No. WO 89/02212. In one embodiment, it is preferred that the first material is deposited by CCVD and/or CACCVD. The deposition of resistive materials by CCVD and/or CACCVD is well known to those skilled in the art. See, for example, U.S. Patent No. 6,208,234 (Hunt et al.) for a description of such processes and apparatuses used.

CCVD has the advantages of being able to deposit very thin, uniform layers which may serve as the dielectric layers of embedded capacitors and resistors. The material can be deposited to any desired thickness; however, for forming resistive material layers by CCVD, thicknesses seldom exceed 50,000 Å. (5 microns). Generally film thicknesses are in the 100 to 10,000 A range, most generally in the 300 to 5000 Å range. Because the thinner the layer, the higher the resistance and the less material, e.g., platinum used, the ability to deposit very thin films is an advantageous feature of the CCVD process. The thinness of the coating also facilitates rapid etching in processes by which discrete resistors are formed.

Although noble metals are conductors, it is found that in depositing noble metals along with relatively minor amounts of oxides, such as silica or alumina, the deposited material becomes highly resistive. Accordingly, metals, such as platinum, containing minor amounts, e.g., 0.1%-5% of an oxide, can serve as resistors in printed circuit boards. For resistive material which is a mixture of a conductive metal and a minor amount of a dielectric material, the metal must be capable of being deposited as a zero valence metal from an oxygen-containing system if the resistive material is to be deposited by CCVD or CACCVD. The criteria for deposition in the zero valence state using a flame is that the metal must have a lower oxidation potential than the lower of the oxidation potential of carbon dioxide or water at the deposition temperature. (At room temperatures, water has a lower oxidation potential; at other temperatures carbon dioxide has a lower oxidation potential.) Zero valence metals which can be readily deposited by CCVD are those having oxidation potentials about equal to silver or below. Thus, silver, gold, platinum and iridium can be deposited by straight CCVD. Zero valence metals having somewhat higher oxidation potentials may be deposited by CACCVD which provides a more reducing atmosphere. Nickel, copper, indium, palladium, tin, iron, molybdenum, cobalt, and lead are best deposited by CACCVD. Herein, metals also include alloys that are mixtures of such zero-valence metals. Silicon, aluminum, chromium, titanium, cerium, zinc, zirconium, magnesium, bismuth, rare earth metals, and phosphorous each have relatively high oxidation potentials, such that if any of the metals mentioned above are codeposited with the appropriate precursors for the dielectric dopants, the metals will deposit in the zero valence state and the dopant will deposit as the oxide. Thus, even when no flame is used the dielectric needs to have a higher oxidation, phospidation, carbidation, nitrodation, or boridation potential, to form the desired two phases.

For more oxygen-reactive metals and alloys of metals, CACCVD may be the process of choice. Even if the metal can be deposited as a zero valence metal by straight CCVD, it may be desirable to provide a controlled atmosphere, i.e., CACCVD, if the substrate material on which it is to be deposited is subject to oxidation. For example, copper and nickel substrates are readily oxidized, and it may be desired to deposit onto these substrates by CACCVD.

Another type of resistive material which can be deposited as a thin layer on a substrate by CCVD is "conductive oxides". In particular, Bi₂Ru₂O₇ and SrRuO₃ are conductive oxides which may be deposited by CCVD. Although these materials are "conductive", their conductivity is relatively low when deposited in amorphous state; thus, a thin layer of such mixed oxides can be used to form discrete resistors. Like conductive metals, such "conductive oxides" may be doped with dielectric materials, such as metal or metalloid oxides, to increase their resistivity. Such mixed oxides may be deposited either as amorphous layers or as crystalline layers, amorphous layers tending to deposit at low deposition temperatures and crystalline layers tending to deposit at higher deposition temperatures. For use as resistors, amorphous layers are generally preferred, having higher resistivity than crystalline materials. Thus, while these materials are classified as "conductive oxides" in their normal crystalline state, the amorphous oxides, even in un-doped form, may produce good resistance. In some cases it may be desired to form low resistance, 1 to 100 Ω, resistors and a conduction-enhancing dopant, such as platinum, gold, silver, copper or iron, may be added. If doped with dielectric material, e.g., metal or metalloid oxides, to increase resistivity of the conducting oxides, or conduction-enhancing material to decrease resistivity of the conducting oxides, such homogeneously mixed dielectric or conduction-enhancing material is generally at levels between 0.1 wt % and 20 wt % of the resistive material, preferably at least 0.5 wt %.

There are a variety of other "conducting materials" which though electrically conducting, have sufficient resistivity to form resistors in accordance with the present invention. Examples include yttrium barium copper oxides and La₁₋ₓSrₓCoO₃, 0 ≤ x ≤ 1, e.g., x = 0.5. Generally, any mixed oxide which has superconducting properties below a critical temperature can serve as electrically resistive material above such critical temperature. Deposition of such a variety of resistive materials is possible with proper selection of precursors selected from those described herein above.

To produce a metal/oxide resistive material film using a CCVD or CACCVD process, a precursor solution is provided which contains both the precursor for the metal and the precursor for the metal or metalloid oxide. For example, to produce platinum/silica films, the deposition solution contains a platinum precursor, such as platinum(II)-acetylacetonate or diphenyl-(1,5-cyclooctadiene) platinum (II) [Pt(COD)] and a silicon-containing precursor, such as tetraethoxysilane. Suitable precursors for iridium and ruthenium include, but are not limited to, tris (norbornadiene) iridium (III) acetyl acetonate ("IrNBD"), and bis (ethylcyclopentadienyl) ruthenium (II). The precursors are mixed generally according to the ratio of metal and enhancing material to decrease the resistivity of the material being deposited, an additional precursor is provided so as to produce minor amounts of the metal oxide or metalloid oxide, e.g., between 0.1 and 20 wt %, preferably at least about 0.5 wt %, of the deposited doped conducting metal oxide. The precursors typically are co-dissolved in a single solvent system, such as toluene or toluene/propane to a concentration (total of platinum, iridium, and/or ruthenium precursors) of from about 0.15 wt% to about 1.5 wt%. This solution is then typically passed through an atomizer to disperse the precursor solution into a fine aerosol and the aerosol is ignited in the presence of an oxidizer, particularly oxygen, to produce the platinum and iridium, ruthenium or mixture thereof zero valence metals(s) and oxide(s). See, e.g. U.S. Patent No. 6,208,234 B1 (Hunt et al.), herein incorporated by reference, for a more complete description of the CCVD process.

A wide variety of materials are suitable to form as the second resistive material layer on the first resistive material. The only requirement for such second resistive material layer is that it be different from the first material and posses a sheet resistivity that is different from the sheet resistivity of the first resistive material layer. Any of the resistive materials described above as being suitable as a first resistive material layer are also suitable for use as a second material.

The present structure having two or more resistive materials, particularly two or more layers of resistive materials, are suitable for the manufacture of resistors, and in particular thin film, embeddable resistors useful in printed wiring board manufacture. Thin film resistors typically have a total thickness of the resistive material portion of 4 µm or less, preferably 2 µm or less, more preferably 1 µm or less and even more preferably 0.5 µm or less.

Resistors typically include a pair of electrodes, each electrode being disposed at opposite ends of a resistive material portion. Such electrodes may be provided in a variety of ways, such as by formation directly on the resistive material or directly formed from an underlying conductive substrate. By way of example, areas of the resistive material to receive the electrode may be catalyzed so that electrodes are deposited, formed, or adhered only to those catalyzed areas. Alternatively, areas that are not to receive the electrode may be masked off, such as by a resist, and the electrode deposited or formed on or otherwise adhered to the unmasked areas.

Suitable electrodes may be formed by any conductive material such as a conductive polymer or a metal. Exemplary metals include, but are not limited to, copper, gold, silver, nickel, tin, platinum, lead, aluminum and mixtures and alloys thereof. "Mixtures" of such metals include non-alloyed metal mixtures and two or more layers of individual metals as in a multilayer electrode. An example of a multilayer electrode is copper having a layer of silver or a layer of nickel on the copper followed by a layer of gold. Such electrodes are typically formed by deposition of a conductive material. Suitable deposition methods include, but are not limited to, electroless plating, electrolytic plating, chemical vapor deposition, CCVD, CACCVD, screen printing, ink jet printing, roller coating and the like. When a conductive paste is used to form the electrode, it is suitably applied by screen printing, ink jet printing, roller coating and the like.

As described above, when the first resistive material is not self-supporting, it is typically applied to a substrate. Conductive substrates are particularly suitable for subsequent formation of resistors, particularly thin film resistors, as the conductive substrates can be used to form the pair of electrodes. This is generally accomplished using a photoresist which is used to form a resist pattern over the layer of resistive material and using an appropriate etchant to remove the resistive material in areas not covered by the resist. For metal/oxide resistive material layers, the etchant chosen is an etchant for the metal component of the resistive material. Typically such etchants are acids or Lewis acids, e.g., FeCl₃ or CuCl₂ for copper. Nitric acid and other inorganic acids (e.g., sulfuric, hydrochloric, and phosphoric) may be used to etch nickel, a variety of other metals which may be deposited as well as conductive oxides.

Noble metals, by their non-reactive nature, are difficult to etch. Aqua regia is a suitable etchant for metals, particularly noble metals, in printed circuit board processes. Aqua regia is made from two well-know acids: 3 parts concentrated (12M) hydrochloric acid (HCl) and 1 part concentrated (16M) nitric acid HNO₃. Thus, the molar ratio of hydrochloric acid to nitric acid is 9:4, although slight variations from this ratio, i.e., 6:4 to 12:4 would be acceptable for etching purposes in accordance with the invention. Because of its corrosive nature and limited shelf life, aqua regia is not sold commercially, but must be prepared prior to use. To reduce its corrosiveness, the aqua regia may be diluted with water up to about a 3:1 ratio of water to aqua regia. On the other hand, the noble metals, such as platinum, are not etched by many of the materials suitable for etching copper, such as FeCl₃ or CuCl₂, thereby allowing for a variety of selective etching options in forming the present resistors. The speed of etching will depend upon several factors including the strength of the aqua regia and the temperature. Typically, aqua regia etching is conducted at a temperature of 55 to 60° C, although this may be varied depending upon the application.

By way of example, the circuitization process begins with a conductive foil, such as a copper foil, to which a layer of a first electrically resistive material has been deposited, such as by electroplating, CCVD or CACCVD. A second electrically resistive material layer is then formed on the first resistive material layer by any of the methods described above to form a multilayer resistive material.

In one embodiment, photoresist layers are applied to both sides, i.e. to the resistive material portion and to the conductive foil. The photoresist covering the resistive material portion is exposed to patterned actinic radiation while the photoresist covering the conductive foil is blanket-exposed to actinic radiation. The photoresists are then developed, giving a structure with a patterned photoresist layer covering the resistive material portion and the blanket-exposed photoresist layer protecting the conductive foil.

The resistive material layer is then selectively etched from areas where the photoresist had been removed. Subsequently, the remaining photoresist is stripped.

Following this, an organic laminate such as a polyimide or a glass-filled epoxy prepreg is applied to the resistive material side. The laminate protects the now-patterned resistive material layer from further processing and subsequently supports patches of the resistive material layer when portions of the conductive foil is subsequently removed from the other side of the resistive material layer.

Next, a photoresist layer is applied to the conductive foil. This is imaged with patterned actinic radiation and developed. Following this, the conductive foil is etched with an etchant which selectively etches the conductive foil but which does not etch the resistive material layer. Stripping of the photoresist leaves the resistor which may subsequently be embedded in an organic dielectric material, such as a B-staged dielectric material including, but not limits to, epoxies, glass-filed, polyimides and the like.

As a variation of this process, it should be noted that if an etchant is used which selectively etches the electrically resistive material layer but does not etch or only partially etches the conductive foil, the use of a resist layer on the conductive foil is not necessary.

In an alternate embodiment, the resistor is laminated to or otherwise adhered to an organic dielectric material prior to circuitization. Such a process is illustrated in Fig. 1.

Referring to Fig. 1, a first resistive material layer **10**, such as a nickel-phosphorus layer, is deposited, such as by electroplating, on a conductive foil **5**. Such conductive foil **5** is typically copper. A second resistive material layer **15** is then deposited on the first resistive material layer **10**. An exemplary second resistive material layer **15** is a platinum-iridium layer which is deposited by CCVD to provide resistive material structure **50**. By "resistive material structure" it is meant a substrate, preferably a conductive substrate, having a first resistive material layer disposed on the substrate and a second resistive material layer disposed on the first resistive material layer, wherein the conductive substrate, first resistive material layer and second resistive material layer are coextensive. In this example, the nickel-phosphorus resistive material layer has a sheet resistivity of 25 Ω/□ and the platinum-iridium resistive material layer has a sheet resistivity of 1000 Ω/□.

Next, an organic dielectric material **20**, such as an epoxy laminate material, is laminated to the second resistive material layer **15**. A photoresist **25**, particularly a dry film photoresist, is then applied to the conductive foil **5**. Photoresist **25** is then imaged and developed to provide the designed pattern. Conductive foil **5** is next removed from the areas bared of resist, such as by etching within cupric chloride.

One of the advantages of the present resistors is that their resistivity may be selected by appropriate selection of the resistive material layer to remain during formation of the resistor. This is further illustrated in Fig. 1 which shows an embodiment where two resistors, each having a different resistivity, are prepared from the same resistive material structure **50**. First resistive material **10** may be removed from the areas bared of conductive foil **5**. In the case of nickel-phosphorus, such material may be removed by etching with copper sulfate. The second resistive material layer **15** is also removed from the areas that are to be free of resistive material, such as areas **45** between resistor structures.

In a next step, another photoresist **30**, such as dry film photoresist, is applied to the conductive foil side of the structure. Photoresist **30** is then imaged and developed to provide the desired pattern of conductive traces (including electrodes). Conductive foil **5** is again removed from areas bared of resists, to provide resistor **40**, which in the above description has a sheet resistivity of 25 Ω/□ due to the presence of the first resistive material layer **10**. Resistor **35** having a different resistivity is obtained by selectively etching or removing the first resistive material layer **10** and leaving the second resistive material layer **15**. In the above example, resistor **35** has a sheet resistivity of 1000 Ω/□.

When referring herein to "etching", the term is used to denote not only the common usage in this art where a strong chemical dissolves or otherwise removes the material of one of the layers, e.g., nitric acid dissolves nickel, but also physical removal, such as laser removal and removal by lack of adhesion. In this regard, and in accordance with an aspect of this invention, it is found that resistive materials, such as doped nickel and doped platinum, deposited by CCVD or CACCVD are porous. The pores are believed to be small, typically of a diameter of a micron or less, preferably of a diameter of 50 nanometers or less (1000 nm = 1 µm). Nevertheless, this permits liquid etchants to diffuse through the electrically resistive material layer and, in a physical process, destroy the adhesion between the resistive material layer and the underlying layer. For example, if the conductive foil layer is copper and the resistive material layer is doped platinum, e.g., platinum/silica, or doped nickel, e.g., Ni/PO₄, cupric chloride could be used to remove exposed portions of the resistive material layer. The cupric chloride does not dissolve either platinum or nickel, but the porosity of the resistive material layer allows the cupric chloride to reach the underlying copper. A small portion of the copper dissolves and the exposed portions of the electrically resistive layer by physical ablation. This physical ablation occurs before the cupric chloride etches the underlying copper layer to any significant extent.

If copper is the conductive material layer, it is sometimes advantageous to use copper foil that has been oxidized, which is commercially available. An advantage of an oxidized copper foil is that a dilute hydrochloric acid ("HCl") solution, e.g., ½ %, dissolves copper oxide without dissolving zero valence copper. Thus, if the electrically resistive material layer is porous, such that the dilute HCl solution diffuses therethrough, HCl can be used for ablative etching. Dissolving the surface copper oxide destroys the adhesion between the copper foil and the electrically resistive material layer.

To minimize processing steps, the photoresists used can themselves be embeddable in materials, such as a permanent etch resist such as that available from Shipley Company, Marlborough, Massachusetts. Then both sides can be processed simultaneously if the etchant does not or only partially etches the conductor. In particular, only the resistor material side photoresist needs to be embeddable and the conductor side can be removed as a final processing step. Alternatively, the photoresists used on the conductor material side can be selected such that it is not removed with a specific stripper used to remove the resistor material side photoresist. Embedable photoresist may decrease tolerance losses due to particular undercutting of resistor material which under cut material will ablate once the photoresist is removed.

To be practically removable by an ablative technique, the resistive material layer must generally be sufficiently porous to an etchant which does not dissolve the electrically resistive material but sufficiently attacks the surface of the underlying material such as to result in loss of interfacial adhesion and ablation of the electrically conductive material within about 2 to 5 minutes. At the same time, such etchant must not substantially attack the underlying material, e.g., copper foil, during the etching period as such would cause excessive undercutting or loss of mechanical strength (i.e., reduce handleability).

In another embodiment, the present invention provides a multi-layer structure which comprises an insulating substrate, a resistive material patch having two or more layers of different resistive material, e.g., platinum/silica formed by CCVD and a nickel-phosphorus layer and a conductive patch (or electrodes), e.g., copper. Preferably, both the resistive material patches and the electrical connection conductive patches are formed by photoimaging techniques. In such structure, the first and second resistive material layers may be coextensive or, alternatively, the first resistive material layer may be coextensive with the conductive patches, i.e. electrode pair.

The multi-layer structure could be patterned using photoimaging technology. In one procedure, the conductive material layer would be covered with a resist, the resist patterned by photoimaging techniques, and, in the exposed areas of the resist, both the conductive material layer and the underlying resistive material layer be etched away, e.g., with aqua regia to give a structure of having a patterned structured resistive material patch (and a patterned conductive material patch or electrode). Next, a second photoresist would be applied, photoimaged, and developed. This time, only the exposed portions of the conductive material patch would be etched away by etchant which would selectively etch the conductive layer, but not the resistive material patch, i.e., FeCl₃ or CuCl₂ in the case of copper as the conductive material layer and platinum/silica as the electrically resistive material. In an alternate procedure, a patterned resist layer would be formed, exposed portions of the conductive material layer etched away, e.g., with FeCl₃, a further patterned resist layer formed, and then the exposed areas of the resistive material layer etched away with aqua regia so as to form the electrical contacts. By either procedure, discrete thin layer resistors are formed by conventional photoimaging techniques common to printed circuitry formation.

While the present resistors could be at the surface of a printed circuit board device, the resistors will, in most cases, be embedded within a multi-layer printed circuit board, for example where the resistor, which was formed on an organic dielectric substrate, such as polyimide or epoxy, is embedded within additional embedding insulating material layers, such as epoxy/fiberglass prepreg material.

Structures containing the present two or more layers of resistive materials may be used in the manufacture of electronic devices, and particularly as resistors embedded in a dielectric material. Thus, the present invention provides an electronic device including a resistor having two or more layers of resistive material, wherein each layer of resistive material is different from the other layers of resistive material. Suitable electronic devices include, but are not limited to printed wiring boards, computers, microprocessors, telecommunications equipment such as mobile or cellular telephones, and the like.

In particular, the present structures are suitable for embedding in a dielectric material in the manufacture of printed wiring boards. Therefore, the present invention also provides an electronic device including a printed wiring board including a resistor having a resistive material portion having two or more layers of resistive material, wherein each layer of resistive material is different from the other layers of resistive material. Also provided by the present invention is an electronic device including a resistor, the resistor including a pair of electrodes and a resistive material portion, the resistive material portion including two or more layers of resistive material, wherein each layer of resistive material is different from the other layers of resistive material.

When the resistive material portion of any of the above described resistors includes two layers of resistive material, such layers may be coextensive or the first resistive material layer may be coextensive with the pair of electrodes. When three layers of resistive material are used, all three layers may be coextensive, the first resistive material layer may be coextensive with the pair of electrodes while the second and third resistive material layers are coextensive, or, alternatively, the first and second resistive material layers may be coextensive with the pair of electrodes.

In general, a sheet of the present resistive material structure is laminated to a sheet of organic dielectric material. The resistive material structure is then etched (such as following photolithography) as described above to form any number of individual resistors within the same plane. It will be appreciated by those skilled in the art that a number of such planes of resistors may be present within a multiplayer printed wiring board.

## Claims

1. A resistor comprising a resistive material portion comprising a first resistive material and a second resistive material, and a pair of electrodes, each electrode being disposed at opposite ends of the resistive material portion.

2. The resistor of claim 1 wherein the first resistive material and second resistive material have a difference in sheet resistivities of 10 Ω/□ or greater.

3. The resistor of any one of claims 1 to 2 wherein at least one of the first and second resistive materials is platinum-based or nickel-based.

4. The resistor any one of claims 1 to 3 wherein the electrodes comprise copper, gold, silver, nickel, tin, platinum, lead, aluminum, or mixtures or alloys thereof.

5. A printed wiring board comprising a resistor of any one of claims 1 to 4 embedded within an organic dielectric material.

6. A method of manufacturing a printed wiring board comprising the step of embedding a resistor any one of claims 1 to 4 within an organic dielectric material.

7. A structure suitable for forming a resistor comprising a conductive substrate, a first resistive material layer disposed on the conductive substrate, and a second resistive material layer disposed on the first resistive material layer.

8. The structure of claim 9 wherein the first resistive material layer and second resistive material layer have a difference in sheet resistivities of 10 Ω/□ or greater.

9. A method of manufacturing a printed wiring board comprising the step of embedding a structure of any one of claims 7 to 8 within an organic dielectric material.
